# EUROPEAN PATENT SPECIFICATION

(11) **EP 3 333 891 B1**
(45) Date of publication and mention of the grant of the patent: **31.08.2022**
(21) Application number: 15880675.2
(22) Date of filing: 11.12.2015
(51) Int. Cl.: H01L 27/32, H01L 27/12, H01L 21/77, H01L 51/52, G02F 1/061

(54) **ARRAY SUBSTRATE HAVING CONDUCTIVE PLANARIZATION LAYER AND PREPARATION METHOD THEREFOR**
ARRAY-SUBSTRAT MIT LEITENDER PLANARISIERUNGSSCHICHT UND HERSTELLUNGSVERFAHREN DAFÜR
SUBSTRAT DE MATRICE À COUCHE DE PLANARISATION CONDUCTRICE ET SON PROCÉDÉ DE PRÉPARATION

(30) Priority: 29.07.2015 CN 201510453722
(43) Date of publication of application: 13.06.2018
(73) Proprietor: BOE Technology Group Co., Ltd., Beijing 100015 (CN)
(72) Inventor: LIU, Ze, Beijing 100176 (CN)
(74) Representative: Klunker IP Patentanwälte PartG mbB
(86) International application number: PCT/CN2015/097124
(87) International publication number: WO 2017/016134

(56) References cited:
- EP-A1- 1 713 137
- EP-A1- 2 144 291
- EP-A2- 1 942 526
- WO-A1-2015/085722
- CN-A- 1 848 448
- CN-A- 101 689 568
- CN-A- 105 118 836
- JP-A- 2007 317 606
- US-A1- 2012 132 916
- US-A1- 2015 001 490

## Description

### TECHNICAL FIELD

The present invention relates to an array substrate having a conductive planar layer, a display device including the same, and a method of manufacturing the same.

### BACKGROUND

In an organic electroluminescent display device, the reflective anode on an array substrate is typically prepared using an ITO/Ag or AlNd/ITO structure, wherein Ag or AINd is used as a reflective electrode and ITO is used as a transparent conductive anode. In the production of the array substrate, the switching element such as a thin film transistor (TFT) on the array substrate will generate some steps. Thus, an organic resin planar layer is generally deposited on the switching element, and then the ITO/Ag or AlNd/ITO electrode is deposited on the organic resin planar layer. However, due to the stress mismatch between the organic resin material and the electrode material, the organic resin planar layer electrode may easily fall off, and the passing rate and long-term stability of the device are problematic.

EP 1 713 137 A1 describes a display with an upper electrical insulation layer covering the active matrix. Each electrooptic element comprises a lower supply electrode that is applied to this insulation layer. The lower electrode includes an organic conducting layer applied directly to the insulation layer and a metal layer covering the organic conducting layer.

Patent application document WO2015085722 discloses an AMOLED display provided with a lower electrode comprising a conductive resin composite material prepared by adding conductive particles, such as nano-sized antimony-doped SnO2, nanoscale ITO or uniformly dispersed nano-silver solution, to a resin and curing the resin.

EP 1 942 526 A1 describes an organic light emitting diode (OLED) display device. In particular, the OLED device includes a plurality of ball-shaped spacers formed over a pixel defining layer.

JP 2007317606 A describes an organic EL display device including a substrate, with a plurality of TFTs formed on the main front surface thereof, with a flattening membrane to cover the upper sides and made of an organic resin, with the plurality of anode electrodes arranged on the upper side of the flattening membrane and electrically connected to the plurality of respective TFTs, with a separation membrane formed so that the plurality of the anode electrodes are individually insulated and isolated from each other and made of the organic resin. An organic EL layer is arranged on the upper side of the anode electrode so as to be electrically connected to the anode electrode, and with a cathode electrode arranged on the upper side of the organic EL layer so as to be electrically connected to the organic EL layer.

US 2012/132916 A1 describes an organic light-emitting display apparatus including an active layer formed on the substrate, a gate electrode, in which a first insulation layer formed on the active layer, a first conductive layer formed on the first insulation layer and comprising a transparent conductive material, and a second conductive layer comprising a metal are sequentially stacked. A pixel electrode, in which a first electrode layer formed on the first insulation layer to be spaced apart from the gate electrode and comprising a transparent conductive material, a second electrode layer formed of a semi-permeable metal and comprising pores, and a third electrode layer comprising a metal are sequentially stacked; An opposite electrode is formed on the EL layer to face the pixel electrode, wherein the second electrode layer comprises nano-sized silver (Ag) particles.

EP 2 144 291 A1 describes an organic light emitting display and a method of fabricating the same, in which the resistance of a cathode electrode is reduced by applying a conductive ink material on the cathode electrode.

Therefore, there is a need in the art for an improved array substrate structure to improve the passing rate and long-term stability of the device.

### SUMMARY OF THE INVENTION

It is an object of the present invention to provide an array substrate, a display device, and a method of manufacturing the array device, which may solve one or more problems in the art.

The object is achieved by the features of the respective independent claims. Further embodiments are defined in the respective dependent claims.

### BRIEF DESCRIPTION OF THE DRAWINGS

In order to clearly illustrate the technical solutions of the embodiments of the present invention, the drawings of the embodiments are briefly described below. Apparently, the drawings described below relate to only some embodiments of the present invention and thus are not limitative of the present invention.
Figure 1 is a schematic view of an array substrate of a top emission type.
Figure 2 is a schematic view of an array substrate according to an embodiment of the present invention.
Figure 3 is a schematic view of an array substrate according to an embodiment of the present invention.
Figures 4-10 are schematic views illustrating a method of manufacturing an array substrate according to embodiments of the present invention.

### DETAILED DESCRIPTION

To make clearer the objects, technical solutions and advantages of the embodiments of the present invention, a clear and full description of the technical solutions of the embodiments of the present invention will be made with reference to the accompanying drawings of the embodiments of the present invention.

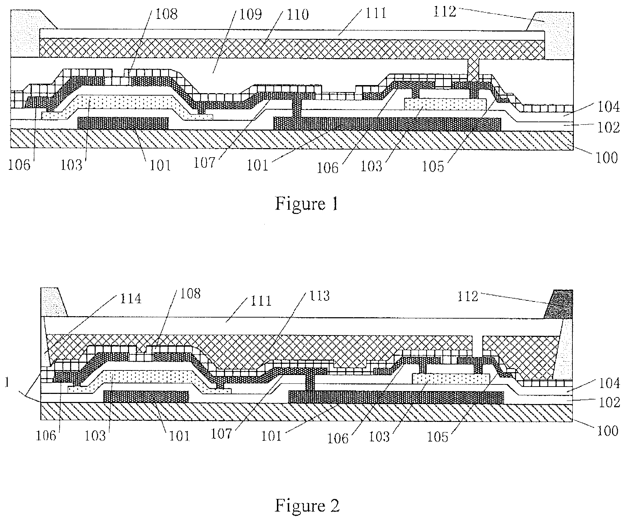

Figure 1 is a view of an array substrate of a top emission type, comprising: a substrate 100, a gate electrode 101 on the substrate, a gate insulation layer 102, a semiconductor layer 103, an etching barrier layer 104, a source electrode 106, a drain electrode 105, an intermediate metal layer 107, an inorganic insulating layer 108 (optional), an organic resin planar layer 109, a reflective electrode 110, a transparent pixel electrode 111, and a pixel defining layer 112.

The terms in the present application have the meanings generally understood by a person skilled in the art.

For example, the term "switching element" has the meaning generally understood by a person skilled in the art. Generally speaking, in an electronic device, the switching element may be a transistor, in particular a thin film transistor. For example, as indicated by the reference sign "1" in Figure 2, the switching element 1 may include a gate electrode 101 on the substrate, a gate insulation layer 102, a semiconductor layer 103, an etching barrier layer 104, a source electrode 106, a drain electrode 105 and an intermediate metal layer 107. The structure of the switching element described herein is merely an exemplary structure, and is not limited thereto according to embodiments of the present invention.

Embodiments of the present invention provide an improved array substrate, a display apparatus comprising the same, and a method of manufacturing the same. On the switching element of the array substrate, a nanoscale metal material, in particular a nanoscale silver material, is applied by a process such as ink-jet printing, and is then sintered to a conductive planar layer (the conductive planar layer may also be used as a reflective electrode), followed by depositing ITO as a top emission pixel electrode. Such array substrate improves the device instability caused by stress between materials, enhances the long-term stability of the device, and simplifies the production process because the planar layer and the pixel electrode are both comprised of inorganic materials. In the present application, the term "long-term stability" refers to the reliability and stability of the device during manufacture and use of the device. By using a conductive planar layer in the manufacture of a non-flexible device, the device will not tend to peel, thereby improving the yield. Flexible devices are often deformed and bent, and by using a conductive planar layer, the device will not tend to peel and shed. Therefore, such long-term stability plays an important part in the process of manufacturing and using a flexible device.

Array substrate is one of the main elements in a display apparatus. Generally speaking, an array substrate includes a plurality of sub-pixel regions, each sub-pixel region forming a sub-pixel, each sub-pixel being capable of emitting light of one color. The luminescent color of each sub-pixel is based on the design. Typically, the three sub-pixels which respectively emit red light, green light and blue light on the array substrate can be used to constitute a pixel. In some embodiments, the four sub-pixels which respectively emit white light, red light, green light and blue light can be used to constitute a pixel.

Generally speaking, the sub-pixel formed in each sub-pixel region at least includes a switching element, a pair of electrodes and an electroluminescent material, the output electrode of the switching element being electrically connected to one electrode of the pair of electrodes and the electroluminescent material being located between the pair of electrodes. Said pair of electrodes generally comprises a pixel electrode, and a common electrode opposite to the pixel electrode. In some embodiments, the pixel electrode is an anode and the common electrode is a cathode.

In one embodiment, the switching element is a transistor, e.g., a thin film transistor. The thin film transistor may be a structure of a top gate type or bottom gate type. There is no limitation to the structure of the thin film transistor of the array substrate suitable for the present invention, which can be a structure generally known to a person skilled in the art.

In the present invention, the array substrate includes a conductive planar layer disposed on the switching element. In the present application, the conductive planar layer has two primary surfaces with one being close to the switching element and the other being close to the pixel electrode, wherein the primary surface close to the switching element is non-planar and the primary surface close to the pixel electrode is planar. The planar primary surface of the conductive planar layer is parallel to the surface of the substrate. The conductive planar layer is mainly comprised of a metal, and can further serve as a reflective substrate in addition to its function of planarization (for example, planarizing the steps formed by the switching element and the like on the array substrate). A pixel electrode is formed on the conductive planar layer. The conductive planar layer is electrically connected to the pixel electrode and is electrically connected to the output electrode of the switching element. In some embodiments, the pixel electrode is electrically and directly connected to the output electrode of the switching element. The pixel electrode is formed directly on the conductive planar layer. The conductive planar layer is a conductive planar layer mainly comprised of a metal. Compared with the stress difference between the organic planar layer and the reflective electrode on the organic planar layer and between the organic planar layer and the inorganic buffer layer below the organic planar layer, the stress difference between the conductive planar layer formed by a metal and the pixel electrode ( ITO) formed on the conductive planar layer and between the conductive planar layer formed by a metal and the inorganic buffer layer formed below the conductive planar layer is smaller, thus improving the instability of the device caused by the stress difference between materials. Because the conductive planar layer can also be used as a reflective electrode, the step of forming a reflective electrode and a planar electrode is integrated into a process step of forming a conductive planar layer, which consequently simplifies the production process of the array substrate according to embodiments of the present invention.

The conductive planar layer is formed by applying a nanoscale metal material and then sintering the nanoscale metal material. The sintered conductive planar layer formed has reflective properties and can be used as a reflective electrode in an array substrate.

In the present application, the term "nanoscale metal material" means that the size of the metal material is less than or equal to 1 nm to less than or equal to 200 nm, and is mainly comprised of a metal. The expression "mainly comprised of a metal" herein means that more than 80% of its ingredients is a metal element, preferably 90%, even 95% or more is a metal element. Of course, the size of the material may also be 1-100 nm, 5-80 nm, 5-50 nm, 5-40 nm, 10-35 nm, 10-30 nm, for example, 10 to 25 nm. The size of the material described herein refers to the size of a smaller extent of the metal material. For instance, if the metal material is microscopically fibrous, then the size is the diameter of the fiber, and if the metal material is microscopically spherical, then the size is the diameter of the sphere. In the present application, when the size of a nanoscale metal material is mentioned, it refers to the average value of the size of the metal material. In general, a nanoscale metal material may have various morphologies, e.g., spherical, fibrous, dendritic, flake and the like, and combinations thereof. When the size of a metal material is of nanoscale, the nanoscale metal material may be sintered at a temperature (e.g., a temperature of 130 for 400 °C) which is much lower than the melting temperature of a bulk metal material of the same kind.

In some embodiments, the nanoscale metal material as a nanoscale metal wire, a metal nano-particle, or a combination thereof. In some embodiments, the nanoscale metal material comprises a nanoscale silver material. These metal nanoscale materials can be commercially available, for example, for example, they can be conductive silver nano-solutions from South Korea Inktec Company. In some embodiments, the nanoscale silver material has a size of from 100 nm to 200 nm and can be sintered at a temperature of 390 to 400 °C or greater. In some embodiments, the nanoscale silver material has a size of from 50 nm to 130 nm and can be sintered at a temperature of 380 to 390 °C or greater. In some embodiments, the nanoscale silver material has a size of from 10 nm to 35 nm and can be sintered at a temperature of 130 to 140 °C or greater. When the nanoscale silver material has a size of smaller than 10 nm, it can be sintered at a lower temperature. Sintering at a relatively lower temperature can reduce the impact on the performance of the array substrate during the sintering process as much as possible.

In some embodiments, the conductive planar layers in different sub-pixel regions are separated and insulated from each other. The planar layers according to embodiments of the present invention are conductive and they are usually electrically connected to the pixel electrodes and switching elements of the sub-pixels. Therefore, the planar layers between various sub-pixels need to be separated and insulated from each other. There is no limitation to the method of separating and insulating them, and they can be separated and insulated using a pixel isolation layer. Alternatively, the insulating effect can also be produced by the gap in space.

In some embodiments, the conductive planar layer has a thickness of greater than 10 nm. In the present application, when "the thickness of the conductive planar layer" is mentioned, it refers to the thickness additionally increased except for leveling off the steps of the switching element. There is no particular limitation to the thickness of the conductive planar layer. However, when the conductive planar layer has a thickness of greater than 10 nm, particularly greater than 30 nm, the conductive planar layer can serve the function of being used as a reflective electrode well to avoid the transmission of light. In some embodiments, the conductive planar layer has a thickness of less than 4 um, less than 3 µm, less than 2 µm, less than 1 µm, less than 100 nm, or less than 50 nm. The limitation of the thickness of the conductive planar layer to less than a certain value is for saving materials, saving the time of the production process, and reducing the thickness of the array substrate.

In some embodiments, the conductive planar layers in different sub-pixel regions are separated and insulated from each other. In some embodiments, the conductive planar layers in different sub-pixel regions are separated and insulated from each other by a pixel isolation layer. In the case of separating the conductive planar layers from each other with a pixel isolation layer, the pixel isolation layer can also be used for separating and insulating pixel electrodes from each other. This depends upon the height of the pixel isolation layer, and under the circumstance that the pixel isolation layer is only used to separate and insulate conductive planar layers from each other, the pixel isolation layer is generally allowed to have a height to be achieved by the conductive planar layers, or a greater height.

In some embodiments, the pixel electrodes in different sub-pixel regions are separated and insulated from each other by another pixel isolation layer. In some embodiments, the another pixel isolation layer may be formed on the pixel isolation layer used for isolating conductive planar layers. This is because in the same sub-pixel region, the pixel electrode and its corresponding conductive planar layer have the same shape and area, and are mutually superimposed.

In some embodiments, the pixel electrode is electrically connected to the switching element via the conductive planar layer. In this case, the conductive planar layer is used as a reflective electrode, and is used for connecting the output electrode and the pixel electrode of the switching element. Under the circumstance that the switching element is a thin film transistor, the output electrode generally refers to the drain electrode of the thin film transistor.

In some embodiments, an inorganic buffer layer is disposed between the switching element and the planar layer. Because the conductive planar layer may affect the electrical properties of the switching element, an inorganic buffer layer can be first formed on the switching element prior to forming the conductive planar layer of the present invention. In this case, the inorganic buffer layer needs to be etched to expose the output electrode of the switching element. In some embodiments, in the process of forming a conductive planar layer, the conductive planar layer may contact the output electrode.

In some embodiments, the material of the inorganic buffer layer may be at least one selected from the group consisting of silicon oxide, silicon nitride and silicon oxynitride. Compared with an organic resin material, the stress between such inorganic materials and conductive planer layers is small, and therefore the electrode material may not tend to fall off. Meanwhile, the inorganic buffer layer may serve to protect the switching element, and to insulate the switching element (other than the output electrode) and the conductive layer planar.

In some embodiments, the inorganic buffer layer has a thickness of from 50 nm to 5000 nm, preferably 50 to 1500 run, more preferably 50 to 500 nm. A too small thickness cannot achieve good protection and insulation effects, while a too large thickness may excessively increase the thickness of the array substrate and is not conducive to saving materials.

In some embodiments, the switching element is a thin film transistor.

In some embodiments, the array substrate further comprises an organic light-emitting layer above the pixel electrode and a transparent electrode above the organic light-emitting layer. In the present application, there is no limitation to the materials for the preparation of a transparent electrode. In some embodiments, the transparent electrode may be manufactured using an ITO electrode material, a carbon nanotube, a carbon nanowire or the like. Carbon nanotubes and nanowires are particularly excellent in terms of mechanical strength and electrical conductivity and are also light transmissive, and therefore can be used as the transparent electrode materials in the array substrate of the present invention. In some embodiments, the pixel electrode is an anode and the transparent electrode above the organic light-emitting layer is a cathode.

The array substrate according to embodiments of the present invention is particularly suitable for the preparation of an OLED device of a top emission type. This is because a conductive planar layer having reflective properties is formed on the switching element, which will reflect the light produced in the light-emitting layer towards the top.

Another aspect of the present invention provides a display device comprising any array described above. Since the display device of the present invention comprises an array substrate having a conductive planar layer of the present invention, it has the advantages brought about by the array substrate.

Another aspect of the present invention further provides a method of manufacturing an array substrate.

In the method of manufacturing an array substrate according to embodiments of the present invention, there is no limitation to the specific method of "forming a switching element on each sub-pixel region of the substrate" or to the type of the switching element.

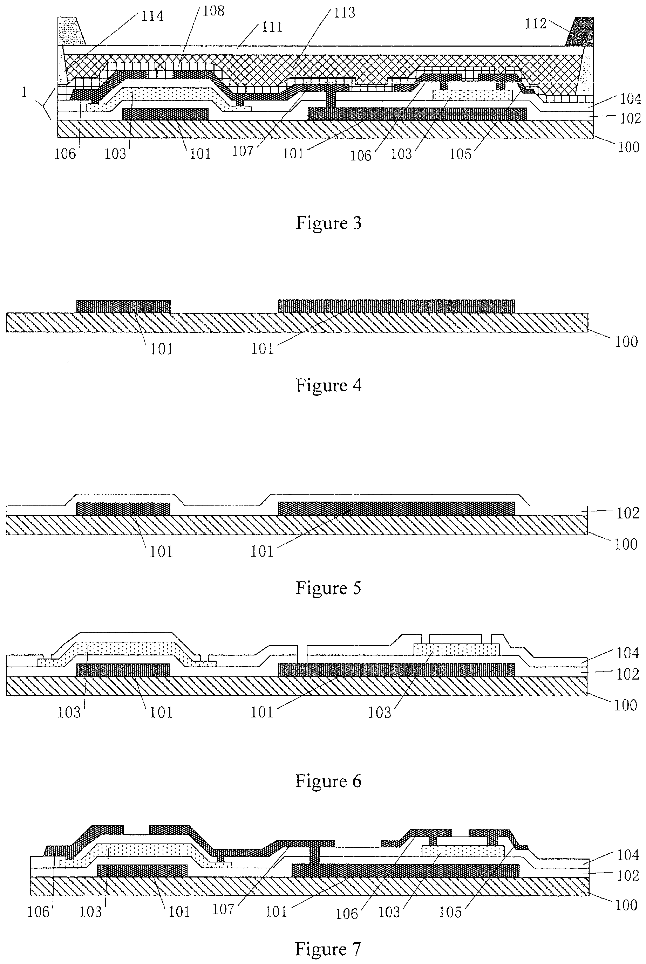

Figure 4-7 are schematic views of a method of preparing a switching element (a thin film transistor of a bottom gate type).

For example, a non-limiting method of preparing a switching element is as follows.

Firstly, depositing a layer of metal, typically molybdenum or copper, on a substrate (100), and forming a bottom gate structure, i.e., a gate electrode (101) (as illustrated in Figure 4) comprising two identical gate electrode metal layers after etching.

Secondly, applying a layer of insulating material on the gate electrode (101) to form a gate insulator (GI) layer (102) (as illustrated in Figure 5).

Thirdly, applying a semiconductor layer material, e.g., indium gallium zinc oxide (IGZO), on the gate insulation layer (102) to form an IGZO layer, i.e., a semiconductor layer (103), and depositing an inorganic non-metal material on the semiconductor layer (103) to form an etching barrier layer (104) after etching; the etching barrier layer is used for preventing damage to the semiconductor layer (103) during subsequent etching of the source electrode metal layer and the drain electrode metal layer (as illustrated in Figure 6).

Fourthly, depositing a layer of metal on the etching barrier layer (104) to respectively form a source electrode (106), a drain electrode (105), and an intermediate metal layer (107) after etching (as illustrated in Figure. 7).

The switching element formed is as illustrated in Figure 7. Figure 7 illustrates the gate electrode (101), the gate insulator (GI) layer (102), the semiconductor layer (103), the etching barrier layer (104), the source electrode (106), the drain electrode (105) and the intermediate metal layer (107) on the substrate (100).

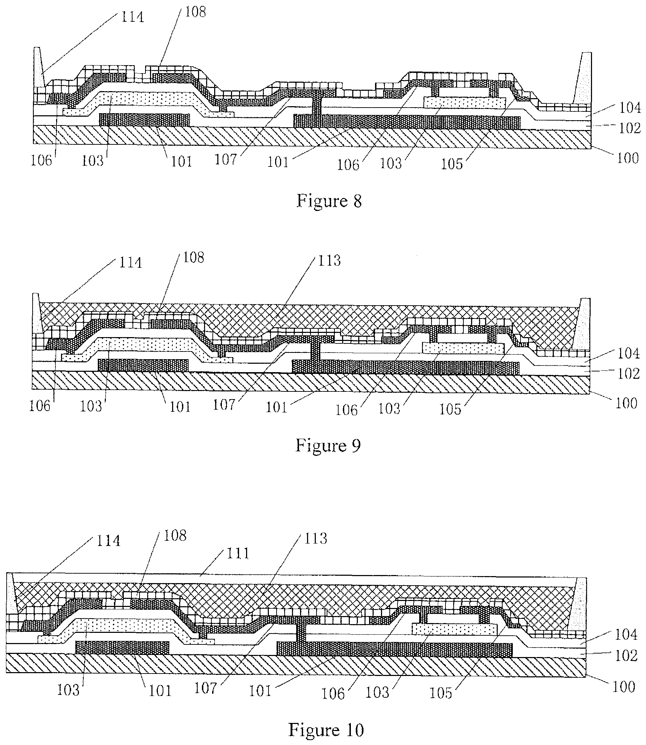

In some embodiments, the method for preparation of a switching element of a bottom gate type further comprises: depositing an inorganic buffer layer on the source electrode metal layer, the drain electrode metal layer and the intermediate metal layer, to form an inorganic buffer layer (108) (as illustrated in Figure 8 ). In some embodiments, the inorganic buffer layer (108) is formed by chemical vapor deposition of silicon nitride, silicon oxide or silicon nitride oxide on the source electrode metal layer, the drain electrode metal layer and the intermediate metal layer. The switching element described in the present application may further comprise an inorganic buffer layer (108).

The step of forming a conductive planar layer on a switching element comprises: applying a nanoscale metal material onto the switching element, followed by sintering to obtain the conductive planar layer.

In some embodiments, the nanoscale metal material is applied by means of ink-jet printing and said sintering is performed at a temperature of 130-600 °C. In some embodiments, the nanoscale metal material is used in the form of a solution of a metal nanoscale material, for example, the conductive silver nano-solution (in which the nanoscale silver particle size is about 25 mn) from South Korea Inktec Company may be used.

In some embodiments, prior to forming the conductive planar layer, an inorganic buffer layer is formed on the switching element, and then is etched to expose the output electrode of the switching element.

In some embodiments, prior to forming the conductive planar layer, a pixel isolation layer is formed, which defines the conductive planar layers on various switching elements. After forming the pixel isolation layer, a conductive planar layer may be formed by the method described above. The pixel isolation layer can also define the pixel electrodes on various switching elements, in which case, a pixel electrode can be formed directly after forming the conductive planar layer.

Under the circumstance that the pixel isolation layer fails to define the pixel electrodes on various switching elements, another pixel isolation layer used for separating and insulating pixel electrodes can be formed, to further form a pixel electrode.

In the method of manufacturing an array substrate of the present invention, an ITO pixel electrode is deposited on the conductive planar layer by a sputtering method.

In some embodiments, after forming a pixel electrode, a pixel defining layer is formed on the pixel electrode, thereby defining the opening ratio of the array substrate.

### Embodiments

All the materials used in the embodiments of the present application are conventional, are commercially available from the market, or can be prepared by conventional methods.

### Comparative Example 1

Figure 1 illustrates an example of an array substrate of a top emission type of the prior art, in which the array substrate of a top emission type comprises: a substrate 100, a gate electrode 101 on the substrate, a gate insulation layer 102, a semiconductor layer 103, an etching barrier layer 104, a source electrode 106, a drain electrode 105, an intermediate metal layer 107, an inorganic buffer layer 108, an organic resin planar layer 109, a reflective electrode 110, a transparent pixel electrode 111, and a pixel defining layer 112.

No pixel isolation layer is formed between the organic resin planar layers in this example. This is because the organic resin planar layers are non-conductive and all pixels share a large planar layer, which will not render electrical connection among the pixel electrodes.

### Embodiment 1

Figure 2 illustrates an array substrate of a top emission type according to an embodiment of the present invention, comprising: a substrate 100 having a plurality of sub-pixel regions (Figure 2 merely exemplifies one sub-pixel region), wherein the array substrate in each sub-pixel region comprises: a switching element 1 disposed on the substrate, a conductive planar layer 113 disposed on the switching element 1, and a pixel electrode 111 disposed on the planar layer, the pixel electrode 111 being electrically connected to the output electrode 105 (i.e., the drain electrode 105) of the switching element 1.

In the embodiment as illustrated in Figure 2, the switching element 1 includes a gate electrode 101 on the substrate, a gate insulation layer 102, a semiconductor layer 103, an etching barrier layer 104, a source electrode 106, a drain electrode 105, and an intermediate metal layer 107. As can be seen from the figure, the switching element 1 as illustrated in Figure 2 is a bottom gate type, which comprises two gate electrodes 101 on the substrate and a gate insulation layer 102 disposed thereon. Two semiconductor layers 103 are provided on the gate insulation layer 102, and are respectively above the two gate electrodes 101. An etching barrier layer 104 is provided above the semiconductor layer 103. A source electrode 106, a drain electrode 105, and an intermediate metal layer 107 are formed above the etching barrier layer 104, wherein the source electrode 106 on the left contacts the semiconductor layer 103 on the left via a through hole, and the source electrode 106 on the right contacts the semiconductor layer 103 on the right via a through hole, the intermediate metal layer 107 contacts the semiconductor layer 103 on the left via a through hole and contacts the gate electrode 101 on the right via another through hole, and the drain electrode 105 contacts the semiconductor layer on the right via a through hole. An inorganic buffer layer 108 is formed above the source electrode 106, the drain electrode 105, and the intermediate metal layer 107. The thickness on the entire plane of the inorganic buffer layer 108 varies slightly, and the steps formed on the switching element 1 are not planarized. A conductive planar layer 113 is provided above the inorganic buffer layer 108, planarizes the steps formed on the switching element 1 and can further serve as a reflective electrode. A pixel electrode 111 is formed on the conductive planar layer, and is electrically connected to the drain electrode 105 via a through hole across the conductive planar layer 113 and the inorganic buffer layer 108. The conductive planar layer 113 is made by sintering a nanoscale silver material. The pixel electrode 111 is formed by ITO that is deposited.

In the present embodiment, the conductive planar layer 113 has the function of reflecting light and is used as a reflective electrode. A through hole is formed in the conductive planar layer 113, and the pixel electrode 111 is directly electrically connected to the drain electrode via the through hole.

A pixel isolation layer 114 is formed between the conductive planar layers 113 in the adjacent sub-pixel regions of the present embodiment. The pixel isolation layer 114 is an insulator and is comprised of an organic or inorganic insulating material. The pixel isolation layer 114 separates and insulates all conductive planar layers from one another.

### Embodiment 2

Figure 3 illustrates an array substrate of a top emission type according to another embodiment of the present invention, in which the array substrate of a top emission type comprises: a substrate 100, a gate electrode 101 on the substrate, a gate insulation layer 102, a semiconductor layer 103, an etching barrier layer 104, a source electrode 106, a drain electrode 105, an intermediate metal layer 107, an inorganic buffer layer 108, a conductive planar layer 113, a reflective electrode 110, a transparent pixel electrode 111, a pixel isolation layer 114 and a pixel defining layer 112. In the present embodiment, the conductive planar layer 113 has the function of reflecting light and is used as a reflective electrode. The conductive planar layer 113 is electrically connected to the drain electrode 105 and the pixel electrode 111 is electrically connected to the drain electrode 105 via the conductive planar layer 113.

A pixel isolation layer 112 is formed between the conductive planar layers 113 in the present embodiment. The pixel isolation layer is an insulator and is comprised of an organic or inorganic insulating material. The pixel isolation layer separates and insulates all conductive planar layers from one another.

In the present embodiment, the part indicated by the reference sign 1 can be called a switching element, which includes a substrate 100, a gate electrode 101 on the substrate, a gate insulation layer 102, a semiconductor layer 103, an etching barrier layer 104, a source electrode 106, a drain electrode 105, and an intermediate metal layer 107.

Embodiment 3 (Preparation of the array substrate of the present invention where a buffer layer is formed)

In the present embodiment, alkali-free glass is used as a substrate to form a switching element thereon required for TFT. As illustrated in Figure 4, a gate metal material (Cu) is deposited and etched to form a bottom gate structure, i.e., a gate electrode (101), of a gate metal layer. Subsequently, as illustrated in Figure 5, an inorganic insulating passivation layer having a film thickness of about 3 µm is formed. As illustrated in Figure 6, the inorganic semiconductor material indium gallium zinc oxide is deposited and patterned, followed by depositing the etching protection layer 104, to form a through hole. As illustrated in Figure 7, a source electrode 106 (which is connected to the semiconductor layer 103 via a through hole as illustrated in the figures), a drain electrode 105 (which is connected to the semiconductor layer 103 via a through hole as illustrated in the figures) and an intermediate metal layer 107 (which is connected to the gate electrode 101 via a through hole as illustrated in the figures) are formed to form a TFT switching element.

As illustrated in Figure 8, an inorganic buffer (SiO₂) layer 108 is deposited and a pixel isolation layer 114 is formed. The drain electrode 105 is exposed after dry etching.

Figure 9 illustrates that the metal ink-jet printing nano-material (the conductive silver nano-solution from South Korea Inktec Company, wherein the nanoscale silver particle size is about 25 nm) is formed into an non-sintered film layer having a thickness of 250 nm (which thickness can be 250 nm to 3 µm) after being ink-jet printed and injected onto the defined inorganic buffer layer 108, and sintered at a temperature of 250°C (the sintering temperature can be 120 to 600 °C, for example, 130 to 560 °C), to obtain a conductive planar layer 113 (which can be used as a reflective electrode) having a thickness of 200 nm. The conductive planar layer 113 is directly electrically connected to the drain electrode 105.

As illustrated in Figure 10, the ITO layer is further deposited on the conductive planar layer 113 by sputtering to form a transparent ITO pixel electrode 111. The pixel electrode 111 is electrically connected to the drain electrode 105 via the planar conductive layer 113.

A pixel defining layer 112 is further formed on the pixel electrode 111, thereby forming the array substrate set forth in Embodiment 2.

In a further step, a positive photoresist (JEM-542, available from JSR Corporation) is coated by a spin coating process on a pixel electrode, and exposure and development are performed, to form a pixel defining layer 112 which defines the opening portion of the pixel electrode.

Further, by means of masking (e.g., by means of thermal evaporation deposition) or ink-jet printing, an OLED light-emitting material is sequentially deposited and formed on the defined pixel electrode, and finally an inorganic conductive oxide material ITO (IZO can also be used) is deposited as a transparent cathode (which has a micro-cavity structure).

Finally, an inorganic barrier layer of 2 µm is deposited by a method of chemical vapor deposition, to form the OLED light-emitting part.

The OLED light-emitting part can be further formed into a display device.

Comparative Example 2 (Preparation of the array substrate of Comparative Example 1)

In this example, alkali-free glass is used as a substrate to form a switching element thereon required for TFT. The TFT switching element formed is the same as that in Embodiment 3.

After forming the TFT switching element, a wet film of acrylic monomers is formed on the switching element by spin coating, a pre-cured film is formed by heating and pre-curing, and the pre-cured film is formed into a planar layer 109 of acrylic resins (Figure 1) having a thickness of 1500 nm in the part other than the through hole by means of masking and exposing. The through hole is etched on the planar layer 109 to expose the drain electrode 105.

The metal Ag that is 200 nm thick is deposited on the planar layer 109 as a reflective electrode 110, and the ITO layer is deposited to form a transparent ITO pixel electrode 111. The reflective electrode 110 is in direct contact with the drain electrode 105. The pixel electrode 111 is electrically connected to the drain electrode 105 via the reflective electrode 110.

Accordingly, the array substrate described in Comparative Example 1 is formed.

### Test 1

The stability of the array substrate is tested, and it is found that the stability is improved.

Evaluation is made by the checkerboard grid method according to JIS K 5400. The specific method is as follows: the array substrate prepared by Embodiment 3 (which corresponds to the array substrate of Embodiment 2) and Comparative Example 2 (which corresponds to the array substrate of Comparative Example 1) is carved into a chestboard grid with a cutter to form 25 grids at an interval of 2 mm. A 3M 600 transparent glass paper adhesive tape is pasted, and then one end of the 3M adhesive tape is held at an angle of 60 degrees for smooth peeling within 0.5-1 seconds. The 3M adhesive tape which has been tested is pasted on a test board for reference and determination. The adhesion state of the coating film will be visually observed after peeling the adhesive tape, where evaluation is made on the basis of the grid with no peel-off as OO, the grid with less than or equal to 1/5 of peel-off as O, and the grid with greater than 1/5 of peel-off as x. The results are illustrated as follows:

**Table 1**

| | Evaluation method | Adhesive tape used | Evaluation result |
|---|---|---|---|
| Embodiment 3 (the array substrate of Embodiment 2) | JIS K 5400 | Type 600 transparent glass paper adhesive tape from 3M Company | OO |
| Comparative Example 2 (the array substrate of Comparative Example 1) | JIS K 5400 | Type 600 transparent glass paper adhesive tape from 3M Company | O |

## Claims

1. An array substrate comprising a substrate (100) having a plurality of sub-pixel regions, wherein the array substrate in each sub-pixel region comprises:
a switching element (1) disposed on the substrate (100),
a sintered nanoscale metal material planarizing layer (113) disposed on the switching element (1), and
an ITO pixel electrode (111) disposed directly on the sintered nanoscale metal material planarizing layer (113),
wherein the ITO pixel electrode (111) is electrically connected to an output electrode (105) of the switching element (1), and
wherein the size of the metal material is less than or equal to 1 nm to less than or equal to 200 nm, and wherein more than 80% of the ingredients of the sintered nanoscale metal material planarizing layer is a metal element.

2. The array substrate according to claim 1, wherein the sintered nanoscale metal material planarizing layer is formed of sintered nanoscale silver material.

3. The array substrate according to claim 2, wherein the nanoscale metal material is a metal nano-wire, a metal nano-particle, or a combination thereof.

4. The array substrate according to any one of claims 1-3, further comprising a pixel isolation layer (114) which separates and insulates the sintered nanoscale metal material planarizing layers (113) in different sub-pixel regions from each other.

5. The array substrate according to any one of claims 1-3, wherein the sintered nanoscale metal material planarizing layer (113) has a thickness of equal to or greater than 10 nm to less than 1 µm.

6. The array substrate according to any one of claims 1-3, wherein the ITO pixel electrode (111) is electrically connected to the output electrode (105) of the switching element (1) via the sintered nanoscale metal material planarizing layer (113), preferably, the switching element (1) is a thin film transistor and the output electrode (105) of the switching element (1) is a drain electrode of the thin film transistor.

7. The array substrate according to any one of claims 1-3, wherein an inorganic buffer layer (108) is disposed between the switching element (1) and the sintered nanoscale metal material planarizing layer (113).

8. The array substrate according to claim 7, wherein the inorganic buffer layer (108) has a thickness of from 50 nm to 1500 nm.

9. A display device comprising the array substrate according to any one of claims Z 1-8.

10. A method of manufacturing an array substrate comprising a substrate (100) having a plurality of sub-pixel regions, wherein for each sub-pixel region the method comprises:
forming a switching (1) element on the substrate (100),
forming a sintered nanoscale metal material planarizing layer (113) on the switching element (1), and
forming an ITO pixel electrode (111) directly on the sintered nanoscale metal material planarizing layer (113),
wherein the ITO pixel electrode (111) is electrically connected to an output electrode (105) of the switching element (1), and
wherein the size of the metal material is less than or equal to 1 nm to less than or equal to 200 nm, and wherein more than 80% of the ingredients of the sintered nanoscale metal material planarizing layer is a metal element,
wherein forming the sintered nanoscale metal material planarizing layer (113) on the switching element (1) comprises:
applying a nanoscale metal material, such as a nanoscale silver material, onto the switching element (1), and then sintering the nanoscale metal material to obtain the conductive planar layer (113).

11. The method according to claim 10, which, prior to forming the sintered nanoscale metal material planarizing layer (113), further comprises:
forming an inorganic buffer layer (108) on the switching element (1) and etching the inorganic buffer layer (108) to expose the output electrode (105) of the switching element (1).

12. The method according to claim 10, wherein the nanoscale metal material is applied by ink-jet printing, screen printing, or transfer printing, and the sintering is performed at a temperature of from 120 to 600 °C, preferably, at a temperature of from 130 to 560 °C.

## Patentansprüche

1. Array-Substrat mit einem Substrat (100), das eine Vielzahl von Sub-Pixel-Bereichen aufweist, wobei das Array-Substrat in jedem Sub-Pixel-Bereich aufweist:
ein Schaltelement (1), das auf dem Substrat (100) angeordnet ist.
eine gesinterte nanoskalige Metallmaterial-Planarisierungsschicht (113), die auf dem Schaltelement (1) angeordnet ist. und
eine ITO-Pixel-Elektrode (111), die direkt auf der gesinterten nanoskaligen Metallmaterial-Planarisierungsschicht (113) angeordnet ist,
wobei die ITO-Pixel-Elektrode (111) elektrisch mit einer Ausgangselektrode (105) des Schaltelements (1) verbunden ist, und
wobei die Größe des Metallmaterials weniger als oder gleich 1 nm bis weniger als oder gleich 200 nm beträgt, und wobei mehr als 80% der Bestandteile des gesinterten nanoskaligen Metalls ein Metallelement sind.

2. Array-Substrat nach Anspruch 1, wobei die gesinterte nanoskalige Metallmaterial-Planarisierungsschicht aus gesintertem Silbermaterial im Nanomaßstab gebildet ist.

3. Das Array-Substrat nach Anspruch 2, wobei das nanoskaligen Metallmaterial ein Metall-Nanodraht, ein Metall-Nanopartikel oder eine Kombination davon ist.

4. Das Array-Substrat nach einem der Ansprüche 1 bis 3, das ferner eine Pixel-Isolationsschicht (114) aufweist, die die gesinterten Schichten (113) aus nanoskaligem Metallmaterial in verschiedenen Sub-Pixel-Bereichen voneinander trennt und isoliert.

5. Array-Substrat nach einem der Ansprüche 1-3, wobei die gesinterte nanoskalige Metallmaterial-Planarisierungsschicht (113) eine Dicke von gleich oder mehr als 10 nm bis weniger als 1 µm aufweist.

6. Array-Substrat nach einem der Ansprüche 1-3. wobei die ITO-Pixel-Elektrode (111) mit der Ausgangselektrode (105) des Schaltelements (1) über die gesinterte nanoskalige Metallmaterialien-Planarisierungsschicht (113) elektrisch verbunden ist. wobei das Schaltelement (1) vorzugsweise ein Dünnschichttransistor ist und die Ausgangselektrode (105) des Schaltelements (1) eine Drain-Elektrode des Dünnschichttransistors ist.

7. Array-Substrat nach einem der Ansprüche 1-3, wobei eine anorganische Pufferschicht (108) zwischen dem Schaltelement (1) und der gesinterten nanoskaligen Metallmaterial-Planarisierungsschicht (113) angeordnet ist.

8. Das Array-Substrat nach Anspruch 7, wobei die anorganische Pufferschicht (108) eine Dicke von 50 nm bis 1500 nm aufweist.

9. Anzeigevorrichtung, die das Array-Substrat nach einem der Ansprüche 1-8 aufweist.

10. Herstellungsverfahren für ein Array-Substrat mit einem Substrat (100), das eine Vielzahl von Sub-Pixel-Regionen aufweist, wobei das Verfahren für jede Sub-Pixel-Region aufweist:
Bilden eines Schaltelements (1) auf dem Substrat (100).
Bilden einer gesinterten nanoskaligen Metallmaterial-Planarisierungsschicht (113) auf dem Schaltelement (1), und
Bilden einer ITO-Pixel-Elektrode (111) auf der gesinterten nanoskaligen Metallmaterial-Planarisierungsschicht (113),
wobei die ITO-Pixel-Elektrode (111) elektrisch mit einer Ausgangselektrode (105) des Schaltelements (1) verbunden ist. und
wobei die Größe des Metallmaterials weniger als oder gleich 1 nm bis weniger als oder gleich 200 nm beträgt, und wobei mehr als 80% der Bestandteile des gesinterten nanoskaligen Metalls ein Metallelement sind,
wobei das Bilden der gesinterten nanoskaligen Metallmaterial-Planarisierungsschicht (113) auf dem Schaltelement (1) aufweist:
Aufbringen eines nanoskaligen Metallmaterials, wie eines nanoskaligen Silbermaterials, auf das Schaltelement (1) und anschließendes Sintern des nanoskaligen Metallmaterials, um die leitfähige planare Schicht (113) zu erhalten.

11. Verfahren nach Anspruch 10, das vor dem Bilden der gesinterten nanoskaligen Metallmaterial-Planarisierungsschicht (113) ferner aufweist:
Bilden einer anorganischen Pufferschicht (108) auf dem Schaltelement (1) und Ätzen der anorganischen Pufferschicht (108). um die Ausgangselektrode (105) des Schaltelements (1) freizulegen.

12. Verfahren nach Anspruch 10, wobei das nanoskalige Metallmaterial durch Tintenstrahldruck. Siebdruck oder Transferdruck aufgebracht wird und das Sintern bei einer Temperatur von 120 bis 600 °C, vorzugsweise bei einer Temperatur von 130 bis 560 °C, durchgeführt wird.

## Revendications

1. Substrat de matrice comprenant un substrat (100) qui comporte une pluralité de régions de sous-pixel(s), dans lequel le substrat de matrice, dans chaque région de sous-pixel(s), comprend :
un élément de commutation (1) qui est disposé sur le substrat (100) ;
une couche de planarisation en matériau métallique nanométrique fritté (113) qui est disposée sur l'élément de commutation (1) ; et
une électrode de pixel en ITO (111) qui est disposée directement sur la couche de planarisation en matériau métallique nanométrique fritté (113) ;
dans lequel l'électrode de pixel en ITO (111) est connectée électriquement à une électrode de sortie (105) de l'élément de commutation (1) ; et
dans lequel la dimension du matériau métallique est inférieure ou égale à 1 nm à inférieure ou égale à 200 nm, et dans lequel plus de 80 % des ingrédients de la couche de planarisation en matériau métallique nanométrique fritté sont un élément métallique.

2. Substrat de matrice selon la revendication 1, dans lequel la couche de planarisation en matériau métallique nanométrique fritté est formée en un matériau à base d'argent nanométrique fritté.

3. Substrat de matrice selon la revendication 2, dans lequel le matériau métallique nanométrique est un nanofil métallique, une nanoparticule métallique ou une combinaison de ceux-ci.

4. Substrat de matrice selon l'une quelconque des revendications 1 à 3, comprenant en outre une couche d'isolation de pixels (114) qui sépare et isole les unes des autres les couches de planarisation en matériau métallique nanométrique fritté (113) dans différentes régions de sous-pixel(s).

5. Substrat de matrice selon l'une quelconque des revendications 1 à 3, dans lequel la couche de planarisation en matériau métallique nanométrique fritté (113) présente une épaisseur égale ou supérieure à 10 nm à moins de 1 µm.

6. Substrat de matrice selon l'une quelconque des revendications 1 à 3, dans lequel l'électrode de pixel en ITO (111) est connectée électriquement à l'électrode de sortie (105) de l'élément de commutation (1) via la couche de planarisation en matériau métallique nanométrique fritté (113), de préférence l'élément de commutation (1) est un transistor à film mince et l'électrode de sortie (105) de l'élément de commutation (1) est une électrode de drain du transistor à film mince.

7. Substrat de matrice selon l'une quelconque des revendications 1 à 3, dans lequel une couche tampon inorganique (108) est disposée entre l'élément de commutation (1) et la couche de planarisation en matériau métallique nanométrique fritté (113).

8. Substrat de matrice selon la revendication 7, dans lequel la couche tampon inorganique (108) présente une épaisseur qui va de 50 nm à 1500 nm.

9. Dispositif d'affichage comprenant le substrat de matrice selon l'une quelconque des revendications 1 à 8.

10. Procédé de fabrication d'un substrat de matrice qui comprend un substrat (100) qui comporte une pluralité de régions de sous-pixel(s), dans lequel, pour chaque région de sous-pixel(s), le procédé comprend :
la formation d'un élément de commutation (1) sur le substrat (100) ;
la formation d'une couche de planarisation en matériau métallique nanométrique fritté (113) sur l'élément de commutation (1) ; et
la formation d'une électrode de pixel en ITO (111) directement sur la couche de planarisation en matériau métallique nanométrique fritté (113) ;
dans lequel l'électrode de pixel en ITO (111) est connectée électriquement à une électrode de sortie (105) de l'élément de commutation (1) ;
dans lequel la dimension du matériau métallique est inférieure ou égale à 1 nm à inférieure ou égale à 200 nm, et dans lequel plus de 80 % des ingrédients de la couche de planarisation en matériau métallique nanométrique fritté sont un élément métallique ; et
dans lequel la formation de la couche de planarisation en matériau métallique nanométrique fritté (113) sur l'élément de commutation (1) comprend :
l'application d'un matériau métallique nanométrique, tel qu'un matériau à base d'argent nanométrique, sur l'élément de commutation (1), puis le frittage du matériau métallique nanométrique pour obtenir la couche plane conductrice (113).

11. Procédé selon la revendication 10, lequel, avant la formation de la couche de planarisation en matériau métallique nanométrique fritté (113), comprend en outre :
la formation d'une couche tampon inorganique (108) sur l'élément de commutation (1) et la gravure de la couche tampon inorganique (108) pour exposer l'électrode de sortie (105) de l'élément de commutation (1).

12. Procédé selon la revendication 10, dans lequel le matériau métallique nanométrique est appliqué au moyen d'une impression par jet d'encre, d'une impression par sérigraphie ou d'une impression par transfert, et le frittage est réalisé à une température qui va de 120 à 600 °C, de préférence à une température qui va de 130 à 560 °C.
